# EUROPEAN PATENT APPLICATION

(11) **EP 4 447 622 A1**
(43) Date of publication of application: **16.10.2024**
(21) Application number: 23794674.4
(22) Date of filing: 31.01.2023
(51) Int. Cl.: H05K 1/11, H05K 3/40, H05K 3/46

(54) **ELECTRONIC DEVICE, AND CIRCUIT BOARD AND MANUFACTURING METHOD THEREFOR**

(30) Priority: 24.04.2022 CN 202210454822
(71) Applicant: Huawei Technologies Co., Ltd., Shenzhen, Guangdong 518129 (CN)
(72) Inventor: LIANG, Xuanling, Shenzhen, Guangdong 518129 (CN); ZHOU, Shaofei, Shenzhen, Guangdong 518129 (CN); LU, Wanglin, Shenzhen, Guangdong 518129 (CN); CHEN, Zhongjian, Shenzhen, Guangdong 518129 (CN)
(74) Representative: Goddar, Heinz J.
(86) International application number: PCT/CN2023/073912
(87) International publication number: WO 2023/207238

(57) **Abstract**

Embodiments of this application relate to the electronic device field, and disclose an electronic device, a circuit board, and a manufacturing method for the circuit board, to resolve a problem that a requirement for a high through-current capability cannot be met because a via having a thick conductive layer cannot be manufactured on a circuit board connected to a high-power chip. The circuit board having a first surface includes a pad array and a first conductive hole that are both disposed on the first surface. The pad array includes at least one pad unit, and the pad unit includes at least two first power pads that are adjacently disposed. Each of the first power pads of the pad unit is connected to a same power network of the chip. The first conductive hole and the pad unit are disposed correspondingly. First power pads in one pad unit are spaced and cover a same corresponding first conductive hole, and are electrically connected to the first conductive hole. A first conductive hole having a large-volume conductive material may be formed on the circuit board in an electroplating manner. A vertical through-current capacity of the circuit board is improved without increasing a manufacturing process of the circuit board.

## Description

This application claims priority to Chinese Patent Application No. 202210454822.1, filed with the China National Intellectual Property Administration on April 24, 2022 and entitled "ELECTRONIC DEVICE, CIRCUIT BOARD, AND MANUFACTURING METHOD FOR CIRCUIT BOARD", which is incorporated herein by reference in its entirety.

### TECHNICAL FIELD

This application relates to the field of electronic device technologies, and in particular, to an electronic device, a circuit board, and a manufacturing method for the circuit board.

### BACKGROUND

Rapid development of technologies such as 5G (5th generation mobile communication technology), cloud computing, big data, Internet of Things, and artificial intelligence drives explosive growth of data and the increasing complexity of algorithms, and also rapidly increases requirements for computing power scale and computing power capabilities. With improvement of chip computing power, a requirement for power of a single chip increases from 450 W to 2000 W or even to 40 kW.

However, a horizontal power supply path of an existing circuit board is excessively long, and cannot meet a through-current requirement of a chip with high computing power. To shorten the power supply path, the circuit board supplies power to the chip in a vertical power supply manner, for example, through a via. However, for a chip with high power consumption, density of chip pins is high, bringing a small spacing between pads connected to the chip pins on the circuit board. A via with a large via diameter cannot be opened on the circuit board. Therefore, a conductive layer with a large thickness cannot be formed in the via to meet a requirement for a high through-current capability.

### SUMMARY

Embodiments of this application provide an electronic device, a circuit board, and a manufacturing method for the circuit board, to resolve a problem that a requirement for a high through-current capability cannot be met because a via having a thick conductive layer cannot be manufactured on an existing circuit board connected to a high-power chip.

To achieve the foregoing objectives, this application uses the following technical solutions.

According to a first aspect, an embodiment of this application provides a circuit board. The circuit board has a first surface. The circuit board includes a pad array and a first conductive hole. The pad array is disposed on the first surface. The pad array includes one or more pad units, the pad unit includes two or more first power pads that are disposed adjacently, and each of the first power pads of the pad unit is configured to be connected to a same power network of a chip. There may be one or more first conductive holes. For a circuit board having one pad unit and one conductive hole, the conductive hole is opened at a position that is on the first surface and that corresponds to the pad unit. All first power pads in the pad unit are spaced and cover a same first conductive hole. In addition, all the first power pads in the pad unit may be connected to the first conductive hole. For a circuit board having a plurality of pad units and a plurality of conductive holes, a quantity of pad units may be equal to a quantity of first conductive holes, or may be greater than a quantity of first conductive holes. The plurality of first conductive holes may be disposed the plurality of pad units correspondingly. The first power pads connected to the same power network are connected to each other, which does not affect functions of the circuit board. Therefore, all first power pads in one pad unit are spaced and cover one corresponding first conductive hole, and are electrically connected to the first conductive hole.

When the foregoing circuit board is connected to a high-power chip, a pin spacing of the chip is small, bringing a small spacing between adjacent first power pads on the circuit board. Because the first conductive hole may occupy positions of two or more adjacent first power pads, an area of the first conductive hole may be large, and a thickness-to-diameter ratio of the first conductive hole is reduced. When the first conductive hole is manufactured, a large-area connection hole may be opened on the first surface of the circuit board. The large-area connection hole has small resistance to an electroplating solution. This helps entering of the electroplating solution, so that the electroplating solution can have a full reaction with a seed layer in the connection hole. In this way, exchange efficiency of the electroplating solution is improved, so that a thick conductive layer is formed in the connection hole, to obtain the first conductive hole. The thick conductive layer improves a through-current capability of the first conductive hole. Therefore, the circuit board in this embodiment of this application can improve a vertical through-current capability of the circuit board without increasing a manufacturing process, so that the vertical through-current capability of the circuit board can reach more than 5 A/hole.

For different through-current requirements, there may be a plurality of structures of the first conductive hole on the circuit board. In some embodiments, the first conductive hole includes a first connection hole, a first conductive layer, and a first filling medium. The first connection hole is opened at the position that is on the first surface and that corresponds to the pad unit. There may be two or more first conductive layers, and a specific quantity of the first conductive layers may correspond to a quantity of first power pads in the pad unit. The plurality of first conductive layers are disposed at an interval in a circumferential direction on a hole wall of the first connection hole. In addition, the plurality of first conductive layers may be electrically connected to the plurality of first power pads in the pad unit respectively. The first filling medium fills the first connection hole, and separates the plurality of first conductive layers. Because the area of the first conductive hole is large, a thick first conductive layer may be formed, so that the circuit board may have a good horizontal through-current capability and a good vertical through-current capability. Therefore, the circuit board is applicable to an application scenario in which a moderate vertical through-current capability is required.

To meet some requirements for a higher vertical through-current capability, in some embodiments of this application, the first conductive hole includes a first connection hole and a conductive medium. The first connection hole is opened at the position that is on the first surface and that corresponds to the pad unit. The conductive medium fills the first connection hole, and the conductive medium covers an entire hole wall of the first connection hole. The conductive medium is electrically connected to all first power pads in one pad unit. The conductive medium covers the entire hole wall of the first connection hole, so that the circuit board has a good horizontal through-current capability. The conductive medium fills the entire first connection hole, and a volume of a conductive material in the first conductive hole is increased, so that a conductive capability of the first conductive hole is further improved. Therefore, an application scenario in which a high vertical through-current capability is required can be met.

In some feasible embodiments of this application, the conductive medium may be a copper pillar, and may directly fill the entire first connection hole by using an electroless plating process and an electroplating process.

In some other feasible embodiments of this application, the conductive medium includes a first conductive layer and a first filling medium. The first conductive layer covers an entire hole wall of the first connection hole. The first filling medium fills the first connection hole, and the first filling medium may be attached to the first conductive layer. The first filling medium is a conductive material. For example, the first filling medium may be conductive silver paste (for example, formed in the first connection hole by using a hole plugging process), conductive copper paste, carbon fiber, silver pillar (a pre-made product that is directly manufactured into a shape fitting the first connection hole having the first conductive layer), copper pillar (a pre-made product), or the like. The first conductive layer and the first filling medium are electrically connected to all first power pads in one pad unit. The conductive medium formed by using the electroplating process and the hole plugging process has fewer defects and has high conductivity reliability.

In addition, according to different distribution and quantities of first power pads in the pad unit, the first conductive hole may have a plurality of shapes. For example, there are four first power pads. Correspondingly, a cross section of the first conductive hole may be rectangular or rhombic. For another example, there are two first power pads. Correspondingly, the first conductive hole may be strip-shaped. The first conductive hole may alternatively be in another shape such as an ellipse, a square, or a triangle.

It should be noted that the circuit board may be a circuit board of a plurality of layers. The first circuit board includes a plurality of layers of subboards, and the plurality of layers of subboards are disposed in a laminated manner. One or more layers of the plurality of layers of subboards are power subboards for power supply. The first conductive hole penetrates through the first surface of the circuit board to at least the power subboard. The first conductive layer of the first conductive hole is electrically connected to a routing layer of the power subboard. Therefore, the first conductive hole may be a blind hole or a through hole. When large routing space is required, the first conductive hole may be designed as the blind hole. The first conductive hole penetrates to only the power subboard, and a metal wire may be disposed at a position that is on a partial subboard located outside between the first surface of the circuit board and the power subboard and that corresponds to the blind hole. In this way, routing space and routing density of the circuit board are improved. When large routing space is not required, the first conductive hole may be designed as the through hole, and an opening operation of the first conductive hole is convenient.

Based on the foregoing descriptions, the circuit board further includes a second conductive hole, and the second conductive hole may be opened on the first surface. In addition, the second conductive hole is strip-shaped. One end of the strip-shaped second conductive hole is located inside the pad array, and the other end of the second conductive hole is located outside the pad array. The pad array further includes a second power pad, and the second power pad is located at an edge of the pad array. A pad adjacent to the second power pad may be a signal pad or a power pad connected to another power network. In other words, the second power pad may be disposed separately. The second power pad covers the end that is of the second conductive hole and that is located inside the pad array. In addition, the second power pad is electrically connected to the second conductive hole. Therefore, for the second power pad that is located at the edge of the pad array and that is disposed separately, a second conductive hole may be formed by extending the conductive hole outwards. A size of the second conductive hole is large, and electroplating may be performed to form a thick conductive layer. This improves a through-current capability of the second conductive hole. A vertical through-current capability of a circuit board having the first conductive hole and the second conductive hole is further improved.

In some embodiments of this application, the second conductive hole includes a second connection hole, a second conductive layer, and a second filling medium. The second connection hole is opened on the first surface, and the second connection hole is strip-shaped. One end of the second connection hole is located inside the pad array, and the other end of the second connection hole is located outside the pad array. The second conductive layer covers a partial hole wall that is in the second connection hole and that is located in the pad array. The second power pad may be electrically connected to the second conductive layer. The second filling medium fills the second connection hole, and is attached to the second conductive layer. The second filling medium may be a non-conductive material, or may be a conductive material. In this way, different vertical through-current requirements are met. The second conductive hole can ensure a horizontal through-current capability, and can further have a high vertical through-current capability. In addition, the second conductive hole can avoid a short circuit caused by penetrating of tin through the second conductive hole during wave soldering of the circuit board.

Similarly, for a solution in which the circuit board is a circuit board of a plurality of layers, the second conductive hole penetrates from the first surface of the circuit board through at least the power subboard. The second conductive layer of the second conductive hole is connected to the routing layer of the power subboard. When large routing space is required, the second conductive hole may be designed as a blind hole. The second conductive hole penetrates to only the power subboard, and a metal wire may be disposed at a position that is on a partial subboard located outside between the first surface of the circuit board and the power subboard and that corresponds to the blind hole. In this way, routing space and routing density of the circuit board are improved. When large routing space is not required, the second conductive hole may be designed as a through hole, and an opening operation of the second conductive hole is convenient.

According to a second aspect, an embodiment of this application further includes an electronic device. The electronic device may be a server, a switch, a bridge (also referred to as a bridge), a repeater, a router, a gateway (also referred to as a protocol converter), or the like. The electronic device includes a chip package structure and the circuit board described in the foregoing embodiment. The chip package structure may be connected to a first surface of the circuit board. Because a structure of the circuit board in the electronic device is the same as that of the circuit board in the foregoing embodiment, both can resolve the same technical problem and achieve the same technical effect. Details are not described herein again.

According to a third aspect, an embodiment of this application further includes a manufacturing method for the foregoing circuit board. The manufacturing method includes the following steps: forming a first conductive hole on a first surface of the circuit board; and forming at least two first power pads on the first conductive hole. Because the manufacturing method for the circuit board can complete manufacturing of the foregoing circuit board, both can resolve the same technical problem and achieve the same technical effect. Details are not described herein again.

Based on the foregoing descriptions, in some embodiments of this application, the forming a first conductive hole on a first surface of the circuit board specifically includes: opening a first connection hole on the first surface of the circuit board; manufacturing a first conductive layer in the first connection hole; and filling, with a first filling medium, the first connection hole having the first conductive layer. The first filling medium may be a conductive material, or may be a non-conductive material.

In some embodiments of this application, the manufacturing a first conductive layer in the first connection hole specifically includes: forming, in an entire hole wall of the first connection hole by using an electroless plating process, a first conductive layer whose thickness is less than a preset thickness; removing a first conductive layer in a part of an area in the first connection hole, to form a plurality of first conductive layers disposed at an interval; and increasing the plurality of first conductive layers in the first connection hole to the preset thickness by using an electroplating process. In this way, the first conductive layer that is manufactured in combination of advantages of the electroless plating process and the electroplating process may be uniform and dense.

In some other embodiments of this application, the manufacturing a first conductive layer in the first connection hole specifically includes: covering a part of an area in the first connection hole with a dry film. forming, in the first connection hole by using an electroless plating process, a first conductive layer whose thickness is less than a preset thickness; removing the dry film in the first connection hole, to obtain a plurality of first conductive layers disposed at an interval; and increasing the plurality of first conductive layers in the first connection hole to the preset thickness by using an electroplating process.

In addition, in some possible embodiments, the forming a first conductive hole on a first surface of the circuit board specifically includes: opening a first connection hole on the first surface of the circuit board; forming a seed layer of a conductive medium in the first connection hole by using an electroless plating process; and increasing a thickness of the seed layer in the first connection hole by using an electroplating process until the entire first connection hole is fully filled, to obtain the first conductive hole.

In addition, for a circuit board of a plurality of layers, the circuit board in embodiments of this application includes at least two laminated board units, and one laminated unit includes a plurality of layers of subboards disposed in a laminated manner. One or more laminated board units are first laminated board units having power subboards for power supply. In addition, the first surface is an outer surface of the first laminated board unit. Therefore, the forming a first conductive hole on a first surface of the circuit board specifically includes: forming a first conductive hole electrically connected to the power subboard on the first surface of the first laminated board unit; and laminating the first laminated board unit and another laminated board unit. The first conductive hole on the first laminated board unit may be a through hole, and the first conductive hole of a blind hole structure may be obtained by laminating the first laminated board unit and the another laminated board unit. A manufacturing process of the first conductive hole is simple.

In addition, in some embodiments of this application, the manufacturing method for the circuit board further includes: forming a second conductive hole on the first surface of the circuit board; and forming a second power pad on the second conductive hole. An opening process of the second conductive hole and an opening process of the first conductive hole may be completed through a same processing procedure. A manufacturing process of the second power pad and a manufacturing process of the first power pad may be completed through a same processing procedure.

### BRIEF DESCRIPTION OF DRAWINGS

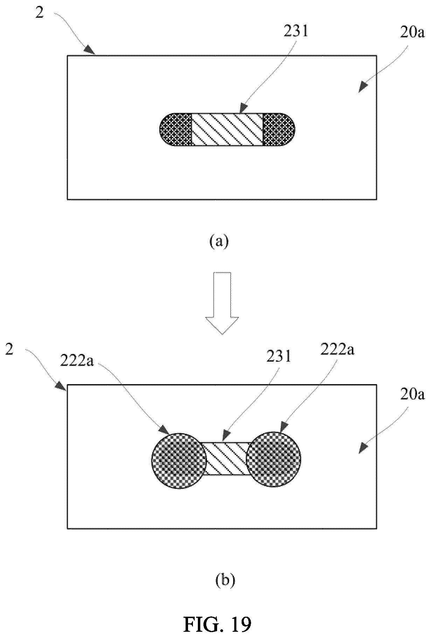

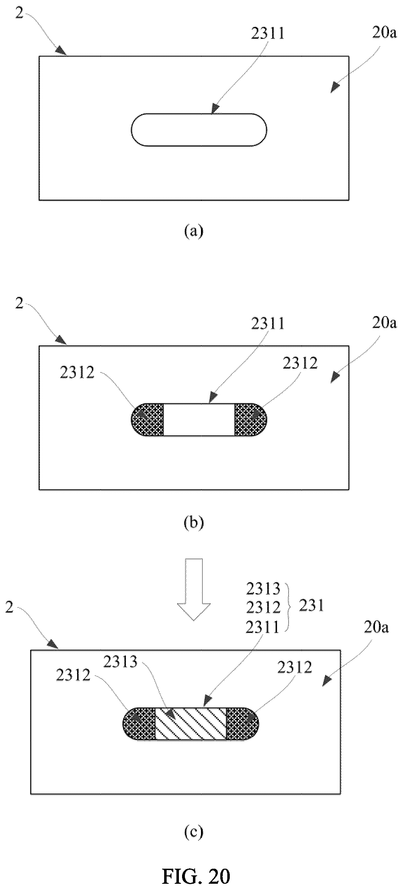

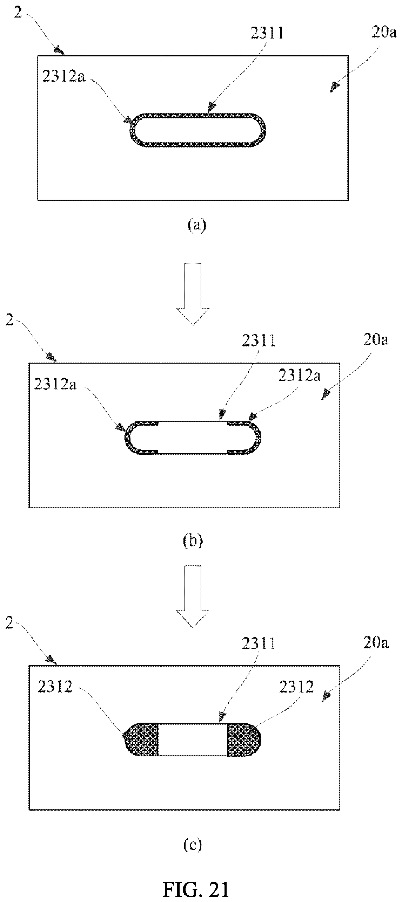

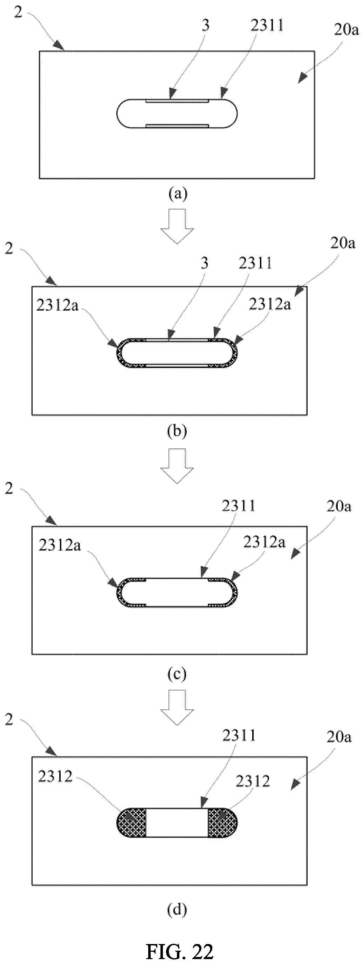

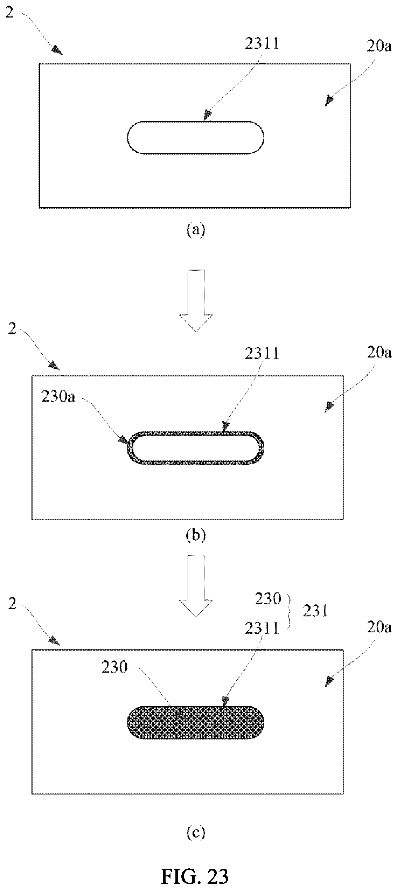

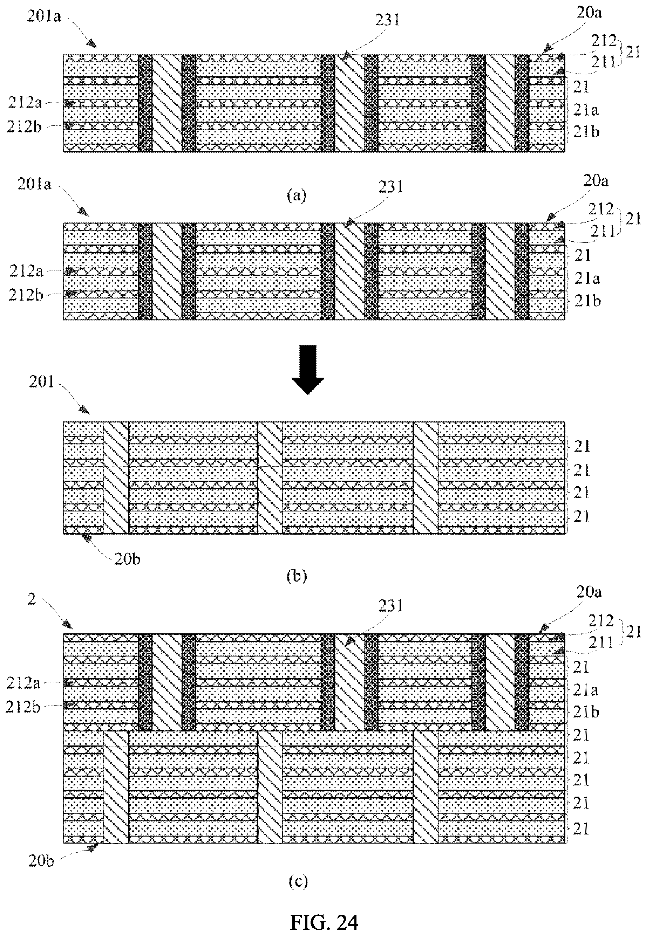

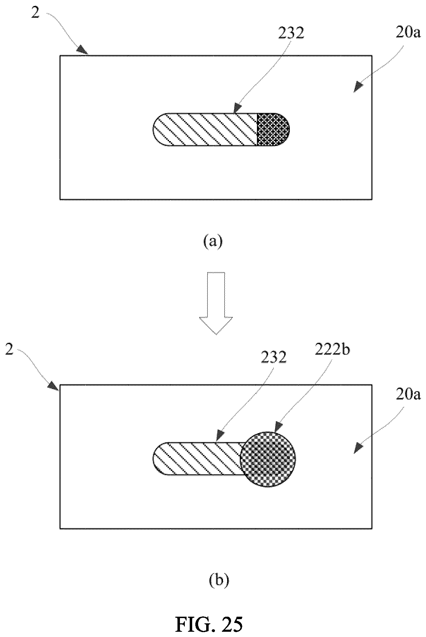

To describe technical solutions in embodiments of this application, the following describes the accompanying drawings used in embodiments of this application.
FIG. 1 is a schematic diagram of a structure of an electronic device being a switch according to an embodiment of this application;
FIG. 2 is a schematic diagram of a structure of a circuit board assembly in an electronic device according to an embodiment of this application;
FIG. 3 is a schematic cross-sectional diagram of a circuit board assembly in an electronic device according to an embodiment of this application;
FIG. 4 is a schematic diagram of a structure of a circuit board, being a circuit board of a plurality of layers, in an electronic device according to an embodiment of this application;
FIG. 5 is a schematic diagram of a structure of a pad array of a circuit board in an electronic device according to an embodiment of this application;
FIG. 6 is a schematic diagram of a structure of another pad array of a circuit board in an electronic device according to an embodiment of this application;
FIG. 7 is a schematic diagram of a structure of a pad array, having a pad unit, of an electronic device according to an embodiment of this application;
FIG. 8 is a schematic diagram of a structure of a circuit board, having a first conductive hole, in an electronic device according to an embodiment of this application;
FIG. 9 is a schematic diagram of a structure of a circuit board, having a pad unit and a first conductive hole, in an electronic device according to an embodiment of this application;
FIG. 10 is a schematic diagram of a structure in which a metal wire is disposed between two power pads in an electronic device according to an embodiment of this application;
FIG. 11 is a schematic cross-sectional diagram of a circuit board, having a first type of first conductive hole, in an electronic device according to an embodiment of this application;
FIG. 12 is a schematic diagram of a structure of a first conductive hole in an electronic device according to an embodiment of this application;
(a) in FIG. 13 is a schematic diagram of a structure of a second type of first conductive hole in an electronic device according to an embodiment of this application;

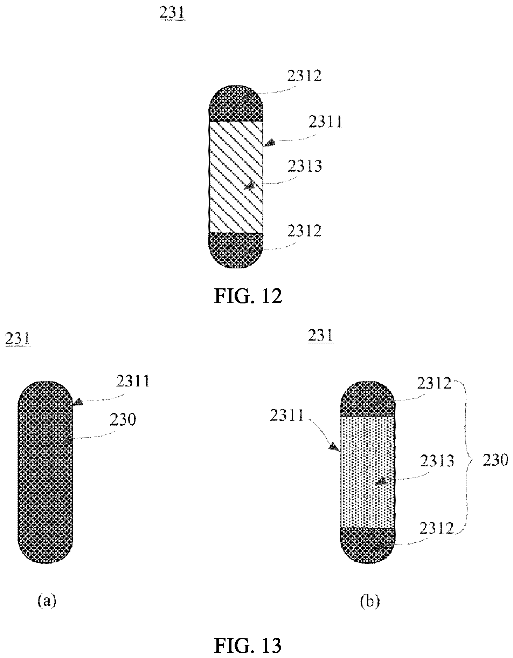

(b) in FIG. 13 is a schematic diagram of a structure of a third type of first conductive hole in an electronic device according to an embodiment of this application;

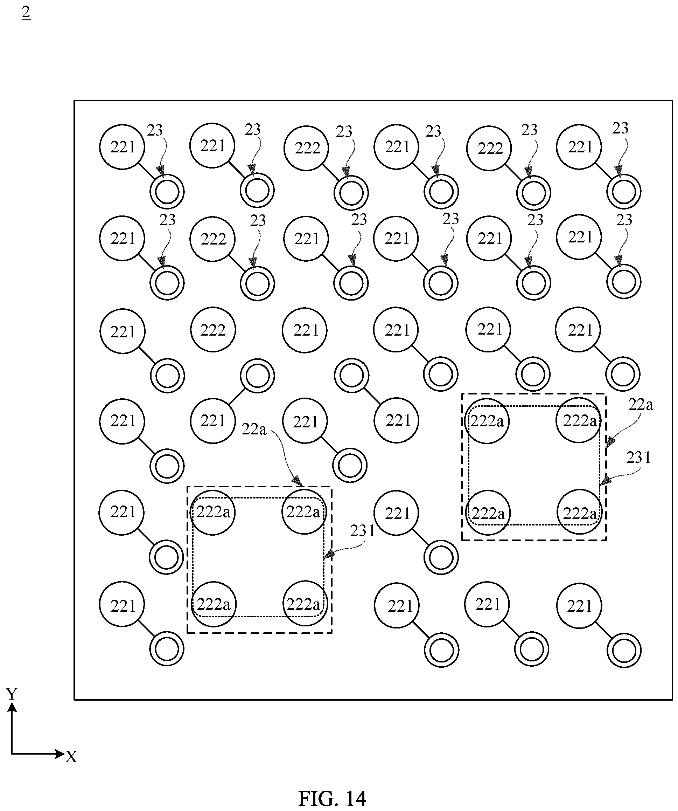

FIG. 14 is a schematic diagram of a structure of a circuit board, having a rectangular first conductive hole, in an electronic device according to an embodiment of this application;

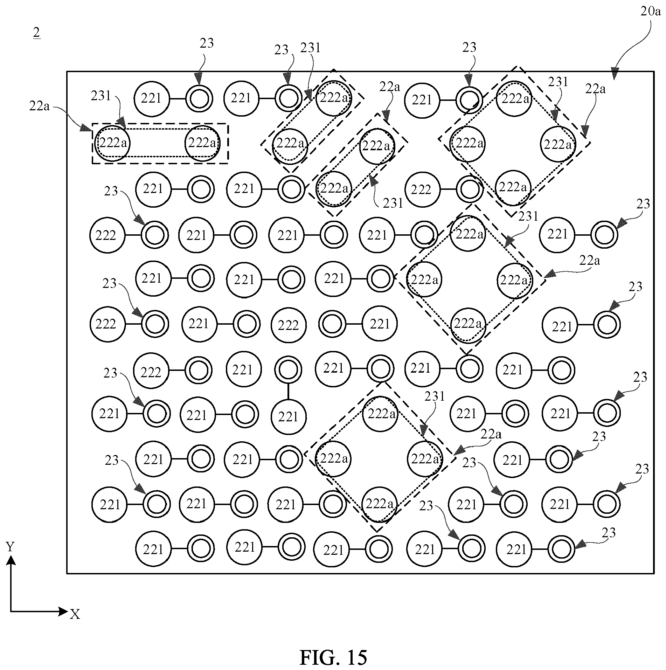

FIG. 15 is a schematic diagram of a structure of a circuit board, having a rhombic first conductive hole and a strip-shaped first conductive hole, in an electronic device according to an embodiment of this application;

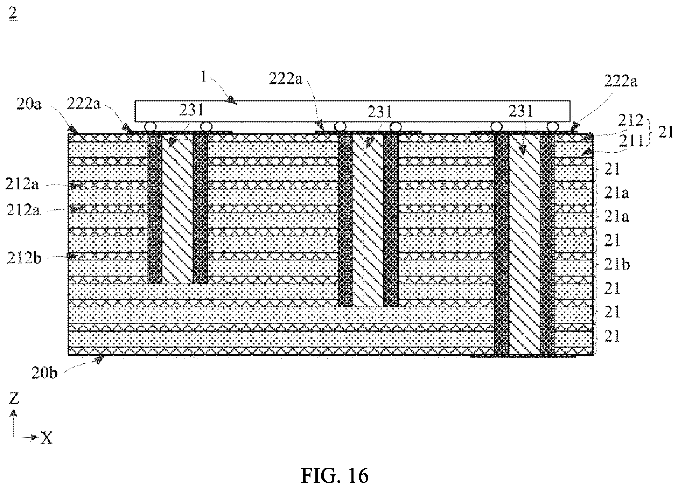

FIG. 16 is a schematic diagram of a structure of a circuit board, having a first conductive hole of a blind hole structure and a first conductive hole of a through hole structure, in an electronic device according to an embodiment of this application;

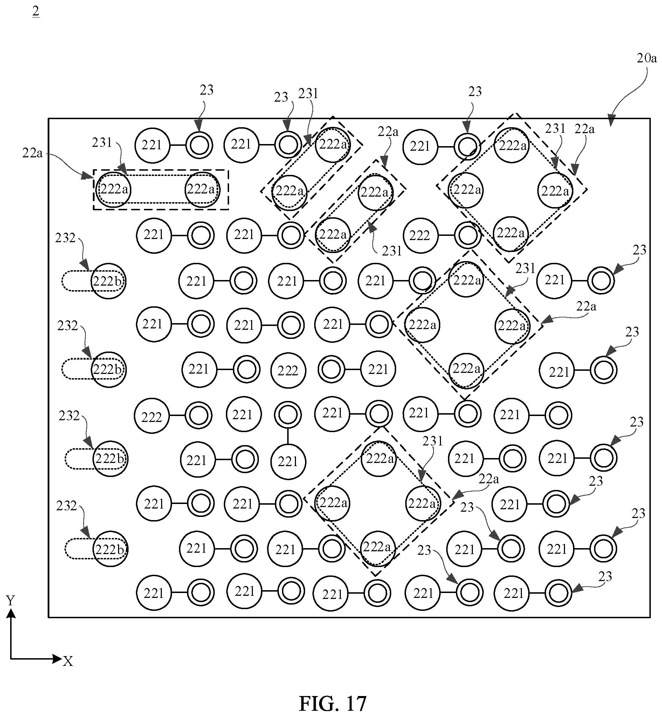

FIG. 17 is a schematic diagram of a structure of a circuit board, having a first conductive hole and a second conductive hole, in an electronic device according to an embodiment of this application;

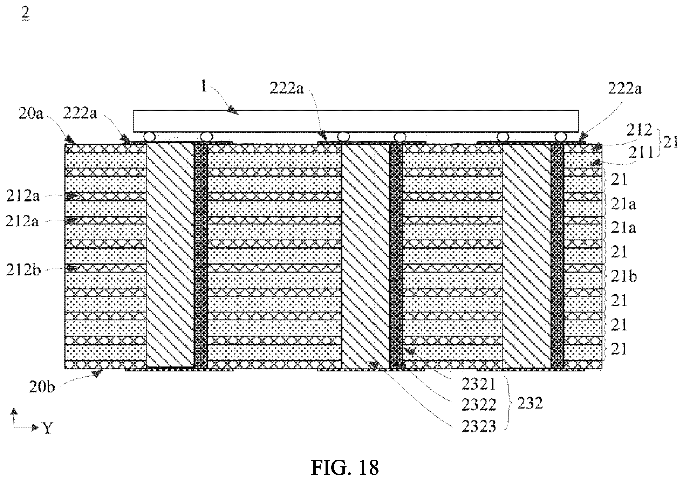

FIG. 18 is a schematic cross-sectional diagram of a circuit board, having a second conductive hole, in an electronic device according to an embodiment of this application;
(a) and (b) in FIG. 19 are schematic diagrams of structures corresponding to various process steps of a manufacturing method for a circuit board according to an embodiment of this application;
(a), (b), and (c) in FIG. 20 are schematic diagrams of structures corresponding to various process steps of forming a first conductive hole on a first surface of a circuit board in a manufacturing method for the circuit board according to an embodiment of this application;
(a), (b), and (c) in FIG. 21 are schematic diagrams of structures corresponding to a first type of various process steps of manufacturing a first conductive layer in a first connection hole in a manufacturing method for a circuit board according to an embodiment of this application;
(a), (b), (c), and (d) in FIG. 22 are schematic diagrams of structures corresponding to a second type of various process steps of manufacturing a first conductive layer in a first connection hole in the manufacturing method for the circuit board according to an embodiment of this application;
(a), (b), and (c) in FIG. 23 are schematic diagrams of structures corresponding to various process steps of forming another first conductive hole on a first surface of a circuit board in a manufacturing method for the circuit board according to an embodiment of this application;
(a), (b), and (c) in FIG. 24 are schematic diagrams of structures corresponding to various process steps of forming a first conductive hole on a first surface of a circuit board having a laminated board unit according to an embodiment of this application; and
(a) and (b) in FIG. 25 are schematic diagrams of structures corresponding to various process steps of forming a second conductive hole on a first surface of a circuit board in a manufacturing method for the circuit board according to an embodiment of this application.

### Reference numerals:

100: electronic device; 10: circuit board assembly; 1: chip package structure; 11: package substrate; 12: chip; 13: molding; 2: circuit board; 201: laminated board unit; 201a: first laminated board unit; 20a: first surface; 20b: second surface; 21: subboard; 21a: signal subboard; 21b: power subboard; 211: substrate; 212: metal routing layer; 212a: signal layer; 212b: power layer; 22: pad array; 22a: pad unit; 220: pad; 221: signal pad; 222: power pad; 222a: first power pad; 222b: second power pad; 23: conductive hole; 230: conductive medium; 231: first conductive hole; 2311: first connection hole; 2312: first conductive layer; 230a, 2312a: seed layer; 2313: first filling medium; 232: second conductive hole; 2321: second connection hole; 2322: second conductive layer; 2323: second filling medium; 24: metal wire; and 3: dry film.

### DESCRIPTION OF EMBODIMENTS

To make the objectives, technical solutions, and advantages of this application clearer, the following further describes embodiments of this application in detail with reference to the accompanying drawings.

The terms "first" and "second" mentioned below are merely intended for a purpose of description, and shall not be understood as an indication or implication of relative importance or implicit indication of a quantity of indicated technical features. Therefore, features defined with "first", "second", and the like may explicitly or implicitly include one or more such features. In descriptions of this application, unless otherwise stated, "a plurality of" means two or more than two.

In addition, in this application, orientation terms such as "up", "down", "left", "right", "horizontal", and "vertical" are defined relative to an orientation in which components are schematically placed in the accompanying drawings. It should be understood that, these directional terms are relative concepts that are used for relative description and clarification, and may vary accordingly based on changes of the orientation in which the components are placed in the accompanying drawings.

In this application, unless otherwise specified and limited, the term "connection" should be understood in a broad sense. For example, the term "connection" may refer to a connection of a mechanical structure or a connection of a physical structure. For example, the connection may be a fixed connection, or may be a detachable connection, or may be an integrated connection, or may be a direct connection, or may be an indirect connection through an intermediate medium. The connection may alternatively be understood that components are in physical contact and electrically conductive, or may be understood that different components in a line structure are connected through a physical line that can transmit an electrical signal, such as a PCB copper foil or a conductor.

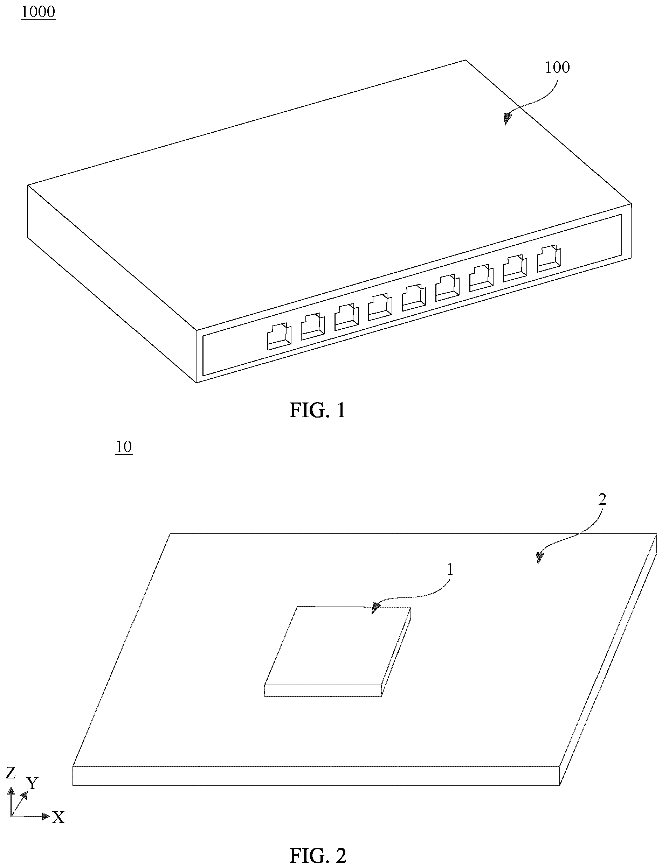

Embodiments of this application include an electronic device. The electronic device may include a server, a switch, a bridge (also referred to as a bridge), a repeater, a router, a gateway (also referred to as a protocol converter), and the like. A specific form of the electronic device is not specially limited in embodiments of this application. For ease of description, the following uses an example in which the electronic device is a switch shown in FIG. 1 for description.

FIG. 1 is a three-dimensional diagram of an electronic device according to some embodiments of this application. It can be learned from the foregoing that the electronic device 1000 in this embodiment is a switch. As shown in FIG. 1 and FIG. 2, the electronic device 1000 may include a housing 100, and a circuit board assembly 10 is disposed in the housing 100. The circuit board assembly 10 includes a chip package structure 1 and a circuit board 2. The chip package structure 1 is mounted on the circuit board 2, and is electrically connected to the circuit board 2. There may be one, two, or more chip package structures 1 on the circuit board 2.

For ease of description of the following, X, Y, and Z coordinate systems may be established in some accompanying drawings. A plane on which the circuit board 2 shown in FIG. 2 is located may be an XY plane. For example, the circuit board 2 shown in FIG. 2 is rectangular. An X axis may be a length direction of the circuit board 2, a Y axis may be a width direction of the circuit board 2, and a Z axis is a direction perpendicular to or approximately perpendicular to the circuit board 2 within a manufacturing tolerance range. It may be understood that, when the circuit board 2 is rectangular, a width of the circuit board 2 is less than a length of the circuit board 2.

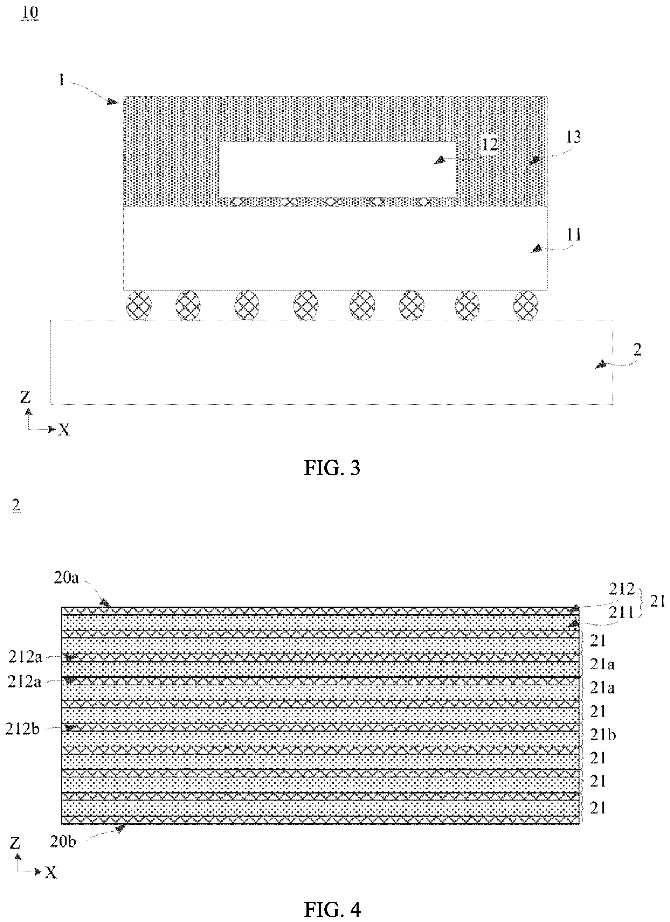

The chip package structure 1 includes a package substrate 11 (substrate, SUB) shown in FIG. 3, a chip 12 disposed on the package substrate 11, and a molding (molding) 13. The package substrate 11 may be electrically connected to the circuit board 2. The package substrate 11 is located between the chip 12 and the circuit board 2. The chip 12 may be a single die (single die), or may be a laminated die structure (that is, a plurality of single dies are laminated). The molding 13 wraps the chip 12 to isolate the chip 12 from external air.

It should be noted that the circuit board 2 may be specifically a circuit board of a plurality of layers. As shown in FIG. 4, the circuit board 2 includes a plurality of layers of subboards 21, and the plurality of layers of subboards 21 are disposed in a laminated manner. Each layer of subboard 21 may include a substrate 211 and a metal routing layer 212, and the substrate 211 is made of an insulation material. The metal routing layer 212 is disposed between substrates 211 of two adjacent layers of subboards 21. For a subboard 21 at the outermost layer of the circuit board 2, there may be two metal routing layers 212 of the subboard 21, and the two metal routing layers 212 may be located on two sides of the substrate 211 respectively. For example, as shown in FIG. 4, a subboard 21 at the bottom layer has two metal routing layers 212.

Still refer to FIG. 4. A plurality of metal routing layers 212 in the circuit board 2 may include a signal layer 212a and a power layer 212b. The signal layer 212a is configured to transmit a signal, and the power layer 212b is configured to supply power to the chip 12. For ease of description, a subboard 21 having the signal layer 212a is referred to as a signal subboard 21a, and a subboard 21 having the power layer 212b is referred to as a power subboard 21b. The circuit board 2 has a first surface 20a and a second surface 20b that are disposed opposite to each other. The chip package structure 1 is connected to the first surface 20a of the circuit board 2. For example, in FIG. 4, the first surface 20a is a top surface of the circuit board 2, and the second surface 20b is a bottom surface of the circuit board 2. It should be noted that, when a position of the circuit board 2 changes, the first surface 20a may alternatively be a bottom surface of the circuit board 2, and the second surface 20b is a top surface of the circuit board 2. The following uses an example in which the first surface 20a is a top surface of the circuit board 2 for description.

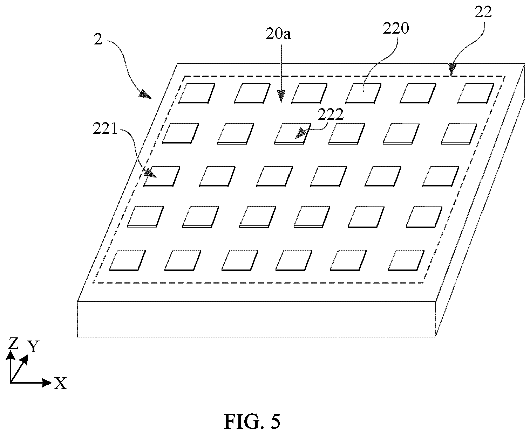

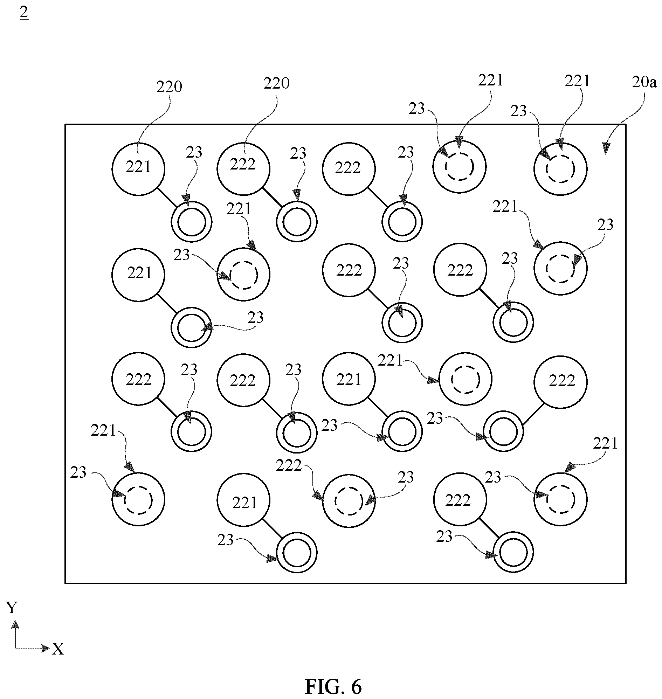

In addition, as shown in FIG. 5, a pad array 22 is disposed on the first surface 20a of the circuit board 2, and the pad array 22 is formed by a plurality of pads 220 that are disposed in an array. The pad 220 may be in a rectangle shown in FIG. 5, or may be in a circle shown in FIG. 6, or may be in another shape. This is not limited in this application. In addition, some metal wires (not shown in FIG. 5 and FIG. 6) may be further disposed on the first surface 20a of the circuit board 2, and the metal wires may be configured to connect electronic components on the circuit board.

As shown in FIG. 6, the plurality of pads 220 of the pad array 22 may include a signal pad 221 and a power pad 222. The signal pad 221 is connected to the signal layer 212a of the signal sub-board 21a, to implement signal transmission between the circuit board 2 and the chip 12. The power pad 222 is connected to the power layer 212b of the power subboard 21b, to supply power to the chip 12.

It may be understood that, if the circuit board 22 is a double-sided circuit board, a pad array may further be disposed on the second surface 20b of the circuit board 2, and a structure form of the pad array on the second surface 20b may be similar to or the same as a structure form of the pad array 22 on the first surface 20a. The following uses the pad array 22 on the first surface 20a of the circuit board 2 as an example for description.

In addition, still refer to 6. A plurality of conductive holes 23 are opened on the first surface 20a of the circuit board 2. The conductive hole 23 may be directly opened on the pad 220. Alternatively, the conductive hole 23 may be disposed near the pad 220, and then connected to the pad 220 through a short metal wire. Some conductive holes 23 of the circuit board 2 may connect the power pad 222 to the power subboard 21b, and some other conductive holes 23 of the circuit board 2 may connect the signal pad 221 to the signal subboard 21a.

It may be understood that, chips 12 with different computing power require different through-current capabilities of the circuit board 2. For a chip 12 with high computing power, if the circuit board 2 mainly uses the metal routing layer 212 to perform horizontal power supply, a horizontal power supply path is long, and a through-current requirement of the chip 12 with high computing power cannot be met. If the circuit board 2 mainly uses the conductive hole 23 to perform vertical power supply, a vertical power supply path is short. Because power of the chip 12 with high computing power is high, pin density of the chip 12 is high. Therefore, a distance between pads, on the circuit board 2, connected to the pins is short, so that only a conductive hole 23 with a small hole diameter can be opened on the circuit board 2. Therefore, a thickness-to-diameter ratio (the thickness-to-diameter ratio is equal to a thickness of the circuit board 2 divided by a hole diameter of the conductive hole 23) of the conductive hole 23 is large. When the thickness-to-diameter ratio of the conductive hole 23 on the circuit board 2 is excessively large, resistance of an electroplating solution entering the conductive hole 23 is large, so that the electroplating solution cannot enter the conductive hole 23 for full reaction. As a result, a thick conductive layer cannot be formed to meet a large through-current requirement.

For example, a center spacing between two adjacent pads 220 on the circuit board 2 is 0.9 mm, and a width (or a length or a diameter) of the pad 220 is 20 mil. On the premise that an internal wiring of the circuit board 2 is met, a maximum diameter of the conductive hole 23 that can be opened on a gap between the pads 220 or inside the pads 220 is 12.5 mil. A maximum through-current capability of a metal layer that can be manufactured in the conductive hole 23 with a diameter of 12.5 mil is approximately 4.3 A per hole. Therefore, a through-current requirement of the chip 12 with high computing power cannot be met.

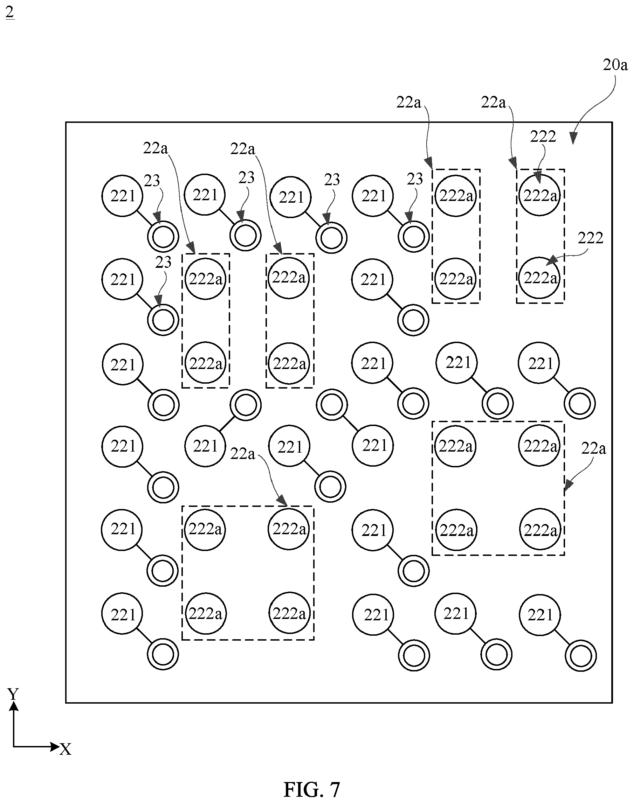

To resolve the foregoing problem, an embodiment of this application provides a circuit board 2, and a conductive hole having a thick conductive layer can be manufactured on the circuit board. The pad array 22 of the circuit board 2 includes a pad unit 22a shown in FIG. 7. The pad unit 22a includes two or more power pads 222 that are disposed adjacently in the pad array 22. All power pads 222 in the pad unit 22a are connected to a same power network of a chip 12. The power pad 222 in the foregoing pad unit 22a is referred to as a first power pad 222a below.

It should be noted that there may be one or more pad units 22a in the pad array 22 in embodiments of this application. A quantity and an arrangement manner of first power pads 222a in a plurality of pad units 22a may be the same, or may be different. This is not limited in this application.

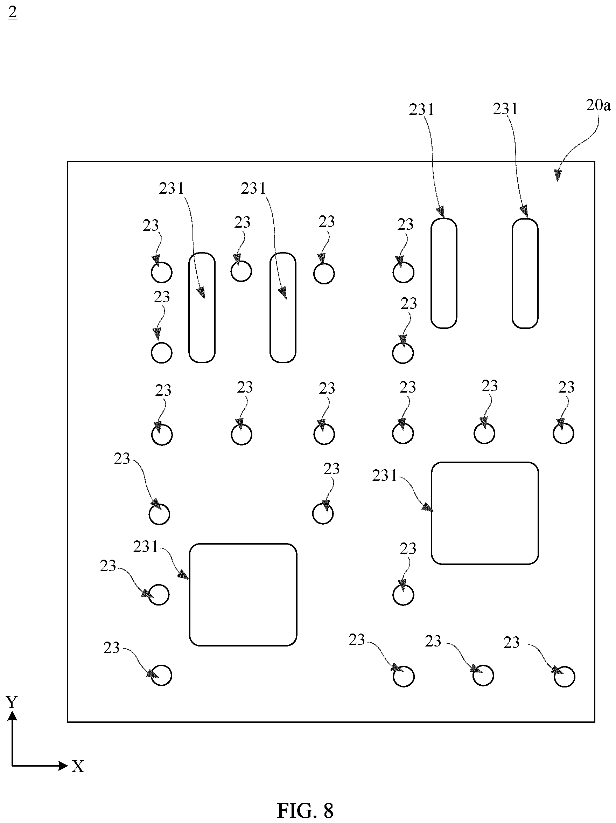

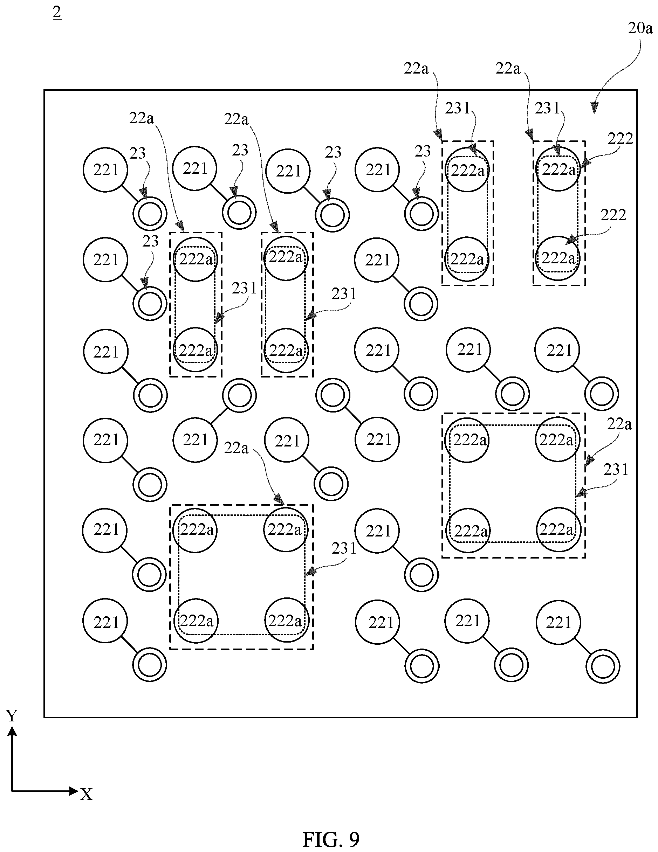

The plurality of conductive holes 23 include a first conductive hole 231 shown in FIG. 8, and the first conductive hole 231 is opened at a position that is on the first surface 20a and that corresponds to the pad array 22. As shown in FIG. 9, all first power pads 222a in the pad unit 22a may be spaced and cover a same first conductive hole 231. In addition, all the first power pads 222a in the pad unit 22a are electrically connected to the first conductive hole 231. Therefore, all the first power pads 222a in the pad unit 22a may be connected to a power subboard 21b through the same conductive hole 23.

Therefore, when the circuit board 2 is connected to the high-power chip 12, a pin spacing of the chip 12 is small, bringing a small spacing between adjacent first power pads 222a on a package substrate 11 and the circuit board 2. Because the first conductive hole 231 may occupy positions of two or more first power pads 222a, an area of the first conductive hole 231 is large, and a thickness-to-diameter ratio of the first conductive hole is reduced. When the first conductive hole 231 is manufactured, a large-area connection hole may be opened on the first surface 20a of the circuit board 2, and the large-area connection hole has small resistance to an electroplating solution. This helps entering of the electroplating solution, so that the electroplating solution can have a full reaction with a seed layer in the connection hole. In this way, exchange efficiency of the electroplating solution is improved, so that a thick conductive layer is formed in the connection hole, to obtain the first conductive hole 231. The thick conductive layer improves a through-current capability of the first conductive hole. Therefore, the circuit board 2 in embodiments of this application can improve a vertical through-current capability of the circuit board 2 without increasing a manufacturing process, so that the vertical through-current capability of the circuit board 2 can reach more than 5 A/hole.

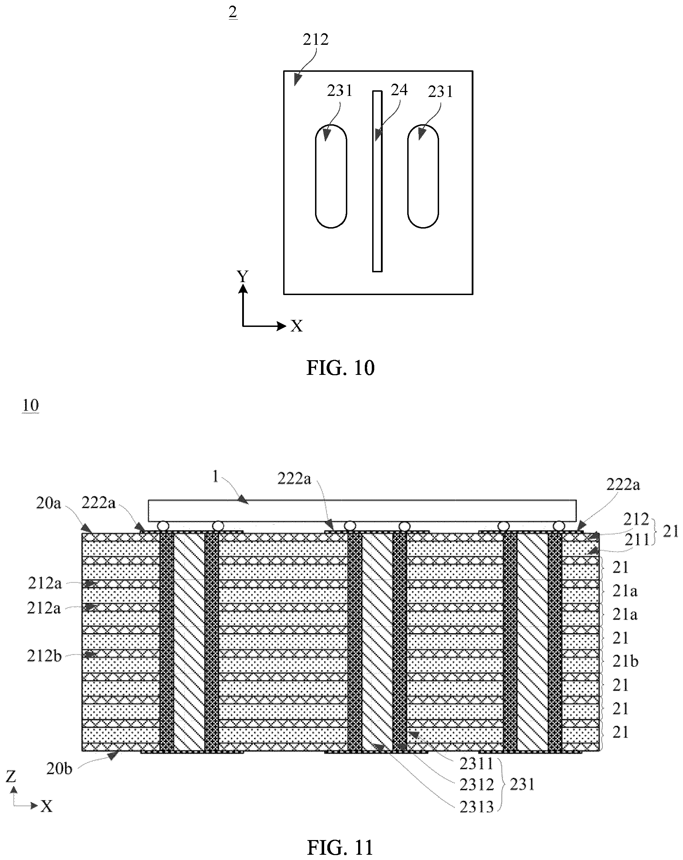

In addition, for a solution in which a metal wire 24 is laid between two first conductive holes 231 on the inner routing layer of the circuit board 2 shown in FIG. 10, the first conductive hole 231 may improve a vertical through-current capability of the circuit board 2 on the basis of ensuring that no short circuit occurs between the first conductive hole 231 and the metal wire 24.

It should be noted that, according to different through-current requirements of the circuit board 2, thicknesses of conductive layers in the first conductive hole 231 are different. Therefore, the first conductive hole 231 may be designed into different structures.

For example, in some embodiments of this application, as shown in FIG. 11, the first conductive hole 231 includes a first connection hole 2311, a first conductive layer 2312, and a first filling medium 2313. The first connection hole 2311 is opened at the position that is on the first surface 20a and that corresponds to the pad unit 22a. The first conductive layer 2312 may be a copper layer. In addition, there are two or more first conductive layers 2312, and a quantity of first conductive layers 2312 may correspond to a quantity of first power pads 222a in the pad unit 22a. In the following descriptions, both the quantity of first conductive layers 2312 and the quantity of first power pads 222a in the pad unit 22a are two. As shown in FIG. 12, the two first conductive layers 2312 are disposed at an interval in a circumferential direction on a hole wall of the first connection hole 2311. The two first conductive layers 2312 may be electrically connected to the two first power pads 222a in the pad unit 22a respectively. Because the first connection hole 2311 occupies a large area of the first surface 20a, a thick first conductive layer 2312 may be formed in the first connection hole 2311. The first conductive layer 2312 can have a reliable connection to the power subboard 21b to ensure a reliable horizontal through-current capability, and has a high vertical through-current capability. A first filling medium 2313 fills the first connection hole 2311, and separates the two first conductive layers 2312. The first filling medium 2313 is a non-conductive material, so that the first filling medium 2313 can separate the two first conductive layers 2312 in an insulation manner. For example, the non-conductive material is resin. In addition, the first filling medium 2313 may be directly manufactured into a shape fitting the first connection hole 2311 having the first conductive layer 2312. "Fitting" means that the first filling medium 2313 is plugged into the first connection hole 2311, and the first filling medium 2313 may be closely attached to the first conductive layer 2312 and the hole wall of the first connection hole 2311. The foregoing embodiment may be applied to a circuit board assembly 10 having a moderate requirement for a through-current capacity.

For a circuit board assembly 10 that has a high requirement for a through-current capacity, the first conductive hole 231 may be of another structure. For example, in some embodiments of this application, as shown in FIG. 13, the first conductive hole 231 includes a first connection hole 2311 and a conductive medium 230. The first connection hole 2311 is opened at the position that is on the first surface 20a and that corresponds to the pad unit 22a. The conductive medium 230 may fill the first connection hole 2311 and cover an entire hole wall of the first connection hole 2311. For example, the conductive medium may be copper, silver, or carbon fiber. The conductive medium 230 is electrically connected to both two first power pads 222a in one pad unit 22a. The conductive medium 230 can have a reliable connection to the power subboard 21b to ensure a reliable horizontal through-current capability. In addition, a volume of the conductive medium 230 is equal to a volume of the first connection hole 2311, that is, the volume of the conductive medium 230 is large, so that the first conductive hole 231 has a strong through-current capability. The first conductive hole 231 with a high through-current capability may be implemented by using a plurality of processes and materials.

For example, as shown in (a) in FIG. 13, the conductive medium 230 in the first conductive hole 231 may be a copper pillar formed in the first connection hole 2311. For example, the conductive medium 230 is directly formed in the first connection hole 2311 by using a electroless plating process and an electroplating process.

For example, as shown in (b) in FIG. 13, the conductive medium 230 in the first conductive hole 231 may include the first conductive layer 2312 and the first filling medium 2313. The first conductive layer 2312 covers the entire hole wall of the first connection hole 2311. For example, the first conductive layer 2312 may be a copper layer. The first filling medium 2313 fills the first connection hole 2311, and the first filling medium 2313 may be attached to the first conductive layer 2312. The first filling medium 2313 is a conductive material. For example, the conductive material is conductive silver paste, conductive copper paste, or carbon fiber. The first filling medium 2313 may be specifically conductive silver paste, conductive copper paste, carbon fiber, silver pillar, copper pillar, or the like. For example, the first filling medium 2313 may be conductive silver paste, conductive copper paste, or carbon fiber that is injected into the first connection hole 2311 by using a filling process, or may be a silver pillar or a copper pillar that is plugged into the first connection hole 2311. Shapes and sizes of the silver pillar and the copper pillar fit the first connection hole 2311 having the first conductive layer 2312. For the first conductive layer formed by using the electroless plating process and the electroplating process and the first filling medium formed by using the hole plugging process, the first conductive layer and the first filling medium have few defects, and reliability of conductive performance is high. The foregoing lists several structures of the first conductive hole 231 in embodiments of this application. For a shape of the first conductive hole 231, the shape of the first conductive hole 231 varies according to a quantity of the first power pads 222a in the pad unit 22a and a distribution form of the plurality of first power pads 222a in the pad unit 22a.

As shown in FIG. 14, one pad unit 22a of the circuit board 2 includes four first power pads 222a, and the four first power pads 222a are disposed adjacently. Two pads 220 of the four pads 220 are located in a same row, and the other two pads 220 of the four pads 220 are located in opposite positions in another adjacent row. After the four pads 220 are connected, a rectangle may be formed. Correspondingly, a first conductive hole 231 may be opened in a rectangle or a rounded rectangle.

The four first power pads 222a in the pad unit 22a may alternatively be arranged in another manner. As shown in FIG. 15, the four first power pads 222a are located in three adjacent rows of the pad array 22, and two of the first power pads 222a are located in the middle row. The four first power pads 222a may be enclosed in a rhombus. Correspondingly, the first conductive hole 231 may be opened as a hole with a rhombic cross section.

In addition, still refer to FIG. 15. Another pad unit 22a on the circuit board 2 includes two adjacently disposed pad units 22a. The two pads 220 may be located in a same row. Alternatively, the two pads 220 may be located in different rows. Correspondingly, the first conductive hole 231 may be opened in a strip shape.

The foregoing schematically describes three first conductive holes 231 of different shapes, to meet circuit design requirements of different chips 12. Certainly, the first conductive hole 231 may alternatively be in a triangle, a trapezoid, an ellipse, a square, or another irregular shape. Therefore, circuit design requirements of more chips 12 can be met.

An opening depth of the first conductive hole 231 varies according to circuit routing requirements of different circuit boards. As shown in FIG. 16, the first conductive hole 231 may be a through hole. An opening operation of the first conductive hole 231 is convenient, and is applicable to an application scenario in which large routing space is not required. The first conductive hole 231 may alternatively be a blind hole. The first conductive hole 231 of the blind hole structure may increase wiring space on a partial subboard that is not penetrated. Therefore, routing space and routing density of the circuit board are improved. It should be noted that a depth of the first conductive hole 231 needs to be at least greater than a routing layer from the first surface 20a to the power subboard 21b. In this way, it is ensured that the first conductive hole 231 may be electrically connected to the metal routing layer 212 of the power subboard 21b.

The first conductive hole 231 may meet a large through-current requirement of the circuit board 2 having two or more adjacent power pads 222. As shown in FIG. 17, for a circuit board 2 including a pad array 22 having a second power pad 222b that is located at an edge and disposed separately, if a first surface 20a of the circuit board 2 has specific space outside the pad array 22, a conductive hole 23 under the second power pad 222b may be extended towards the outside of the pad array 22 to form a strip-shaped second conductive hole 232, so as to meet a large through-current requirement of the circuit board 2. One end of the second conductive hole 232 in a length direction is located inside the pad array 22, and the other end of the second conductive hole 232 in the length direction is located outside the pad array 22. The second power pad 222b that is located at the edge and disposed separately may cover the end that is of the second conductive hole 232 and that is located inside the pad array 22. In addition, the second power pad 222b is electrically connected to the second conductive hole 232.

Similarly, because a length of the second conductive hole 232 is long, when the second conductive hole 232 is manufactured, a large-area connection hole may be opened on the first surface 20a of the circuit board 2. The large-area connection hole has small resistance to an electroplating solution. This helps entering of the electroplating solution, so that the electroplating solution can have a full reaction with a seed layer in the connection hole. In this way, a thick conductive layer is formed in the connection hole, and the conductive layer may have a high through-current capability. Therefore, the through-current capability of the circuit board 2 may be further improved.

A structure of the second conductive hole 232 may be similar to a structure of some first conductive holes 231. For example, as shown in FIG. 18, the second conductive hole 232 includes a second connection hole 2321, a second conductive layer 2322, and a second filling medium 2323. The second connection hole 2321 may be opened on the first surface 20a of the circuit board 2. In addition, the second connection hole 2321 is strip-shaped. One end of the second connection hole 2321 in the length direction is located inside the pad array 22, and the other end of the second connection hole 2321 in the length direction is located outside the pad array 22. The second conductive layer 2322 may be a copper layer. The second conductive layer 2322 may specifically cover a hole wall that is in the second connection hole 2321 and that is located in the pad array 22. The second power pad 222b may cover the second conductive layer 2322, and is electrically connected to the second conductive layer 2322. The second filling medium 2323 fills the second connection hole 2321, and is attached to the second conductive layer 2322. The second filling medium 2323 is a non-conductive material. For example, the second filling medium 2323 is resin. In addition, the second filling medium 2323 may be directly manufactured into a shape fitting the second connection hole 2321 having the second conductive layer 2322. The second filling medium 2323 may be directly plugged into the second connection hole 2321, and an operation is convenient. The second conductive hole may further avoid a short circuit caused by penetrating of tin through the second conductive hole during wave soldering of the circuit board.

Similarly, according to a requirement for a different through-current capability of the circuit board 2, a second conductive layer 2322 with a proper thickness is selected and manufactured to meet the through-current requirement. In addition, a second conductive hole 232 with a proper depth is selected according to a different routing requirement of the circuit board 2. The second conductive hole 232 may be a through hole. An opening operation of the second conductive hole 232 is convenient, and is applicable to an application scenario in which large routing space is not required. The second conductive hole 232 may alternatively be a blind hole. The second conductive hole 232 of the blind hole structure may increase wiring space on a partial subboard that is not penetrated. However, a depth of the second conductive hole 232 needs to be at least greater than a routing layer from the first surface 20a to the power subboard 21b. In this way, it is ensured that the second conductive hole 232 may be electrically connected to the metal routing layer 212 of the power subboard 21b.

Based on the structure of the foregoing circuit board, an embodiment of this application further includes a manufacturing method for the foregoing circuit board. As shown in FIG. 19, the manufacturing method for the circuit board includes the following steps:
S100: Form a first conductive hole 231 on a first surface 20a of the circuit board 2.

For example, in (a) in FIG. 19, the first conductive hole 231 may be opened on the first surface 20a of the circuit board 2.

S200: Form at least two first power pads 222a on the first conductive hole 231.

For example, in (b) in FIG. 19, the two first power pads 222a are formed on the first conductive hole 231.

The foregoing the manufacturing method for the circuit board may implement manufacturing of the circuit board in the foregoing embodiment, and both can resolve the same technical problem. Details are not described herein again.

In some embodiments, as shown in FIG. 20, the forming a first conductive hole 231 on a first surface 20a of the circuit board 2 specifically includes:
S101a: Open a first connection hole 2311 on the first surface 20a of the circuit board 2.

For example, as shown in (a) in FIG. 20, the first connection hole 2311 may be opened on the first surface 20a of the circuit board 2 by using a drilling machine or a numerical control machine tool.

S 102a: Manufacture a first conductive layer 2312 in the first connection hole 2311.

For example, as shown in (b) in FIG. 20, the first conductive layer 2312 is formed in the first connection hole 2311 by using an electroplating process, an electroless plating process, or the like.

S103a: Fill a first filling medium 2313 in the first connection hole 2311 having the first conductive layer 2312.

For example, as shown in (c) in FIG. 20, the first connection hole 2311 having the first conductive layer 2312 is filled with the first filling medium 2313. The first filling medium 2313 may be a conductive material or a non-conductive material. The filling operation may be completed by using a hole plugging process.

Based on the structure of the first conductive layer 2312 in the first conductive hole 231 shown in (b) in FIG. 20, for example, as shown in FIG. 21, the manufacturing a first conductive layer 2312 in the first connection hole 2311 specifically includes:
S1021a: Form, in an entire hole wall of the first connection hole 2311 in an electroless plating manner, a first conductive layer 2312 whose thickness is less than a preset thickness.

For example, as shown in (a) in FIG. 21, seed layers 2312a of two first conductive layer 2312 are formed through electroless plating in the entire hole wall of the first connection hole 2311, and a thickness of the seed layer 2312a is less than a preset thickness of the first conductive layer 2312.

S1022a: Remove a first conductive layer 2312 in a part in the first connection hole 2311, to form a plurality of first conductive layers 2312 disposed at an interval.

For example, as shown in (b) in FIG. 21, the seed layers 2312a of the first conductive layers 2312 in two regions are mechanically removed from the first connection hole 2311.

S1023a: Increase the plurality of first conductive layers 2312 of the first connection hole 2311 to the preset thickness in an electroplating manner.

For example, as shown in (c) in FIG. 21, electroplating is performed in the first connection hole 2311 having the seed layer 2312a to increase thicknesses of the two seed layers 2312a to the preset thickness, so as to form two first conductive layers 2312 of the preset thickness. For another example, as shown in FIG. 22, the manufacturing a first conductive layer 2312 in the first connection hole 2311 specifically includes:
S1021b: Cover a part of an area in the first connection hole 2311 with a dry film 3.

For example, as shown in (a) in FIG. 22, dry films (dry film) 3 are pasted on two regions in the first connection hole 2311.

S1022b: Form, in the first connection hole 2311 by using an electroless plating process, a first conductive layer 2312 whose thickness is less than a preset thickness.

For example, as shown in (b) in FIG. 22, seed layers 2312a of two first conductive layer 2312 are formed through electroless plating in the first connection hole 2311, and a thickness of the seed layer 2312a is less than a preset thickness of the first conductive layer 2312.

S1023b: Remove the dry film in the first connection hole 2311, to obtain a plurality of first conductive layers 2312 disposed at an interval.

For example, as shown in (c) in FIG. 22, the dry films in the first connection hole 2311 are removed, to obtain a first connection hole 2311 having two seed layers 2312a disposed at an interval.

S1024b: Increase the plurality of first conductive layers 2312 in the first connection hole 2311 to the preset thickness by using an electroplating process.

For example, as shown in (d) in FIG. 22, in the first connection hole 2311 having the seed layer 2312a, thicknesses of the two seed layers 2312a are increased to the preset thickness by using an electroplating process, to form two first conductive layers 2312 of the preset thickness.

In some other embodiments of this application, as shown in FIG. 23, the forming a first conductive hole 231 on a first surface 20a of the circuit board 2 specifically includes:
S101b: Open a first connection hole 2311 on the first surface 20a of the circuit board 2.

For example, as shown in (a) in FIG. 23, one first connection hole 2311 is opened on the first surface 20a of the circuit board 2.

S 102b: Form a seed layer 230a of a conductive medium 230 in the first connection hole 2311 by using an electroless plating process.

For example, as shown in (b) in FIG. 23, the seed layer 230a of the conductive medium 230 is formed through electroless plating in the first connection hole 2311.

S103b: Increase a thickness of the seed layer 230a in the first connection hole 2311 by using an electroplating process until the entire first connection hole 2311 is fully filled, to obtain a first conductive hole 231.

For example, as shown in (c) in FIG. 23, in the first connection hole 2311 having the seed layer 230a, a thickness of the first conductive layer 2312 is increased by using an electroplating process until the entire first connection hole 2311 is filled.

The first conductive holes 231 of different depths may be completed by using different processing procedures in the manufacturing process of the circuit board 2. For example, if the first conductive hole 231 is a through hole, for a circuit board 2 having a plurality of layers of subboards 21, the first conductive hole 231 may be directly opened on the plurality of layers of subboards 21 that are laminated. If the first conductive hole 231 is a blind hole, for circuit boards 2 of different structures, the first conductive hole 231 may be completed in different processing procedures in manufacturing processes of the circuit boards 2.

For example, the circuit board 2 includes two or more laminated board units 201 disposed in a laminated manner. Any laminated board unit 201 includes a plurality of layers of subboards 21 that are disposed in a laminated manner. One or more laminated board units 201 in the circuit board 2 are first laminated board units 201a having power subboards 21b for power supply. To be specific, one subboard 21 in the first laminated board unit 201a is a power subboard 21b. The first surface 20a is an outer surface, far away from the power subboard 21b, on the first laminated board unit 201a. After the step of manufacturing the two or more than two laminate board units 201 of the circuit board 2 is completed, refer to FIG. 24. The forming a first conductive hole 231 on a first surface 20a of the circuit board 2 specifically includes:
S1011: Form a first conductive hole 231 electrically connected to the power subboard 21b on the first surface 20a of the first laminate board unit 201a.

For example, as shown in (a) in FIG. 24, a subboard 21 at the bottom layer of the first laminate board unit 201a is a power subboard 21b. A through hole is directly opened on the first surface 20a of the first laminate board unit 201a to form the first conductive hole 231.

S1012: Laminate the first laminated board unit 201a and another laminate board unit 201.

For example, the circuit board 2 includes two or more laminated board units 201 shown in (b) and (c) in FIG. 24, and the first laminated board unit 201a is laminated above the other laminated unit 201.

In some other embodiments of this application, the first conductive hole 231 of the blind hole structure shown in (c) in FIG. 24 may be directly formed on the first surface 20a of the circuit board of a plurality of layers obtained after the lamination is completed.

In addition, in some embodiments of this application, as shown in FIG. 25, the manufacturing method for the circuit board 2 further includes:
S300: Form a second conductive hole 232 on the first surface 20a of the circuit board 2.

For example, as shown in (a) in FIG. 25, a strip-shaped second conductive hole 232 may be formed on the circuit board 2. It should be noted that a forming process of the first conductive hole 231 and a forming process of the second conductive hole 232 may be performed simultaneously.

S400: Form a second power pad 222b on the second conductive hole 232.

For example, as shown in (b) in FIG. 25, the second power pad 222b may be manufactured on the second conductive hole 232 of the circuit board 2. It should be noted that a manufacturing process of the second power pad 222b and a manufacturing process of the first power pad 222b may be completed through a same processing procedure.

In addition, the specific step of forming the strip-shaped second conductive hole 232 on the first surface 20a of the circuit board 2 may be similar to the step of forming the first conductive hole 231 on the first surface 20a of the circuit board 2. A strip-shaped second connection hole 2321 may be opened on the circuit board 2 by using a drilling machine or a numerical control machine tool. Then, a second conductive layer 2322 is formed by using an electroless plating process, an electroplating process, or the like. Finally, a second filling medium 2323 is formed in the second connection hole 2321 having the second conductive layer 2322. In this way, the second conductive hole 232 is obtained.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A circuit board, having a first surface, wherein the circuit board comprises:
a pad array, wherein the pad array is disposed on the first surface, the pad array comprises at least one pad unit, the pad unit comprises at least two first power pads that are adjacently disposed, and each of the at least two first power pads in the pad unit is configured to be connected to a same power network of a chip; and
at least one first conductive hole, wherein the first conductive hole is opened at a position that is on the first surface and that corresponds to the pad unit; and the at least two first power pads in the pad unit are spaced and cover the same first conductive hole, and are electrically connected to the first conductive hole.

2. The circuit board according to claim 1, wherein the first conductive hole comprises:
a first connection hole, wherein the first connection hole is opened at the position that is on the first surface and that corresponds to the pad unit;
a first conductive layer, wherein the first conductive layer comprises at least two first conductive layers, and the at least two first conductive layers are disposed at an interval in a circumferential direction on a hole wall of the first connection hole, and are electrically connected to the at least two first power pads in the pad unit respectively; and
a first filling medium, wherein the first filling medium is a non-conductive material; and the first filling medium fills the first connection hole, and separates the at least two first conductive layers.

3. The circuit board according to claim 1, wherein the first conductive hole comprises:
a first connection hole, wherein the first connection hole is opened at the position that is on the first surface and that corresponds to the pad unit; and
a conductive medium, wherein the conductive medium fills the first connection hole and covers an entire hole wall of the first connection hole; and the conductive medium is electrically connected to each of the at least two first power pads in the pad unit.

4. The circuit board according to claim 3, wherein the conductive medium comprises:
a first conductive layer, wherein the first conductive layer covers the entire hole wall of the first connection hole; and
a first filling medium, wherein the first filling medium fills the first connection hole and is attached to the first conductive layer; the first filling medium is a conductive material; and the first conductive layer and the first filling medium are electrically connected to each of the at least two first power pads in the pad unit.

5. The circuit board according to any one of claims 1 to 4, wherein a cross section of the first conductive hole is rectangular, rhombic, or strip-shaped.

6. The circuit board according to any one of claims 1 to 5, wherein the circuit board comprises:
a plurality of layers of subboards, wherein the plurality of layers of subboards are disposed in a laminated manner, and at least one layer of the plurality of layers of subboards is a power subboard for power supply; and
the first conductive hole penetrates from the first surface of the circuit board to at least the power subboard, and the first conductive layer of the first conductive hole is electrically connected to a routing layer of the power subboard.

7. The circuit board according to any one of claims 1 to 6, wherein the circuit board further comprises:
a second conductive hole, wherein the second conductive hole is opened on the first surface, the second conductive hole is strip-shaped, one end of the second conductive hole is located inside the pad array, and the other end of the second conductive hole is located outside the pad array; and
the pad array further comprises a second power pad, wherein the second power pad is located at an edge of the pad array; and the second power pad covers the end that is of the second conductive hole and that is located inside the pad array, and is electrically connected to the second conductive hole.

8. The circuit board according to claim 7, wherein the second conductive hole comprises:
a second connection hole, wherein the second connection hole is opened on the first surface and is strip-shaped, one end of the second connection hole is located inside the pad array, and the other end of the second connection hole is located outside the pad array;
a second conductive layer, wherein the second conductive layer covers a hole wall that is in the second connection hole and that is located inside the pad array, and the second power pad is electrically connected to the second conductive layer; and
a second filling medium, wherein the second filling medium is a non-conductive material; and the second filling medium fills the second connection hole and is attached to the second conductive layer.

9. The circuit board according to claim 8, wherein the circuit board comprises:
the plurality of layers of subboards, wherein the plurality of layers of subboards are disposed in the laminated manner, and the at least one layer of the plurality of layers of subboards is the power subboard for power supply; and
the second conductive hole penetrates from the first surface of the circuit board to at least the power subboard, and the second conductive layer of the first conductive hole is connected to the routing layer of the power subboard.

10. An electronic device, comprising a chip package structure and the circuit board according to any one of claims 1 to 9, wherein the chip package structure is connected to a first surface of the circuit board.

11. A manufacturing method for the circuit board according to any one of claims 1 to 9, comprising the following steps:
forming a first conductive hole on a first surface of the circuit board; and
forming at least two first power pads on the first conductive hole.

12. The manufacturing method for the circuit board according to claim 11, wherein the forming a first conductive hole on a first surface of the circuit board specifically comprises:
opening a first connection hole on the first surface of the circuit board;
manufacturing a first conductive layer in the first connection hole; and
filling, with a first filling medium, the first connection hole having the first conductive layer.

13. The manufacturing method for the circuit board according to claim 12, wherein the manufacturing a first conductive layer in the first connection hole specifically comprises:
forming, in an entire hole wall of the first connection hole by using an electroless plating process, a first conductive layer whose thickness is less than a preset thickness;
removing a first conductive layer in a part of an area in the first connection hole, to form a plurality of first conductive layers disposed at an interval; and
increasing the plurality of first conductive layers in the first connection hole to the preset thickness by using an electroplating process.

14. The manufacturing method for the circuit board according to any one of claims 11 to 13, wherein the circuit board comprises at least two laminated board units, one of the laminated board units comprises a plurality of layers of subboards disposed in a laminated manner, the at least one laminated board unit is a first laminated board unit having a power subboard for power supply, and the first surface is an outer surface of the first laminated board unit; and
the forming a first conductive hole on a first surface of the circuit board specifically comprises:
forming, on the first surface of the first laminated board unit, the first conductive hole electrically connected to the power subboard; and
laminating the first laminated board unit and another laminated board unit.

15. The manufacturing method for the circuit board according to any one of claims 11 to 14, wherein the manufacturing method for the circuit board further comprises:
forming a second conductive hole on the first surface of the circuit board; and
forming a second power pad on the second conductive hole.
